(19)

Europäisches
Patentamt
European
Patent Office
Office européen
des brevets

(11) **EP 1 933 387 A2**

(12) **EUROPEAN PATENT APPLICATION**

(43) Date of publication:
    **18.06.2008 Bulletin 2008/25**

(51) Int Cl.:
    **H01L 31/0216** (2006.01)

(21) Application number: **07118946.8**

(22) Date of filing: **22.10.2007**

(84) Designated Contracting States:
    **AT BE BG CH CY CZ DE DK EE ES FI FR GB GR HU IE IS IT LI LT LU LV MC MT NL PL PT RO SE SI SK TR**
    Designated Extension States:
    **AL BA HR MK RS**

(30) Priority: **17.11.2006 KR 20060114039**

(71) Applicant: **Samsung SDI Co., Ltd.**
    **Suwon-si**
    **Gyeonggi-do (KR)**

(72) Inventors:
    • **Lee, Wha-Sup,**
      **Legal & IP Team, Samsung SDI Co., LTD.,**
      **Gyeonggi-do (KR)**
    • **Lee, Ji-Won,**
      **Legal&IP Team,Samsung SDI Co.,Ltd.,**
      **Gyeonggi-do (KR)**
    • **Park, Joung-Won,**
      **Legal&IP Team,Samsung SDI Co.,LTD.,**
      **Gyeonggi-do (KR)**
    • **Choi, Jae-Man,**
      **Legal & IP Team,Samsung SDI Co.,Ltd.,**
      **Gyeonggi-do (KR)**

    • **Ahn, Kwang-Soon,**
      **Legal & IP Team,Samsung SDI Co.,LTD.,**
      **Gyeonggi-do (KR)**
    • **Kang, Moon-Sung,**
      **Legal & IP Team,Samsung SDI Co.,LTD.,**
      **Gyeonggi-do (KR)**
    • **Shin, Byong-Cheol,**
      **Legal & IP Team,Samsung SDI Co.,LTD.,**
      **Gyeonggi-do (KR)**
    • **Kwon, Moon-Seok,**
      **Legal & IP Team,Samsung SDI Co.,LTD.,**
      **Gyeonggi-do (KR)**
    • **Moon, Soo-Jin,**
      **Legal & IP Team, Samsung SDI Co.,LTD.,**
      **Gyeonggi-do (KR)**
    • **Lee, Jae-Kwan,**
      **Legal & IP Team, Samsung SDI Co.,LTD.,**
      **Gyeonggi-do (KR)**

(74) Representative: **Hengelhaupt, Jürgen et al**
    **Anwaltskanzlei**
    **Gulde Hengelhaupt Ziebig & Schneider**
    **Wallstrasse 58/59**
    **10179 Berlin (DE)**

(54) **Dye-sensitized solar cell**

(57) A dye-sensitized solar cell includes a first electrode including a conductive transparent substrate; a light absorption layer disposed on a side of the first electrode; a second electrode facing the first electrode; and an electrolyte disposed between the first and the second electrode. The light absorption layer includes a porous membrane that includes semiconductor particulates, and a photosensitized dye adsorbed on a surface of the porous membrane. The porous membrane has a membrane density ranging from 0.83 to 1.97mg/mm$^3$, wherein the membrane density is a ratio of a porous membrane volume relative to a semiconductor particulate mass.

FIG.1

10

11
12
13
14

EP 1 933 387 A2

**Description**

**BACKGROUND OF THE INVENTION**

**(a) Field of the Invention**

The present invention relates to a dye-sensitized solar cell and a method of fabricating the same.

**(b) Description of the Related Art**

Various research studies have been carried out in an attempt to develop alternative energy sources that can replace conventional fossil fuels and solve an approaching energy crisis. Particularly, extensive research studies are underway to find ways for using alternative energy sources, such as wind power, atomic power, and solar power, as substitutes for petroleum resources, which are expected to be depleted within several decades. Among the alternative energy sources, solar cells use solar energy that is virtually infinite and environmentally friendly. A solar cell can be a silicon (Si) solar cell.

It is, however, difficult to use Si solar cells because the production cost is relatively high and there are difficulties in improving cell efficiency. A dye-sensitized solar cell that can be produced at a low cost may overcome the above described problems of the Si solar cells.

Differing from a Si solar cell, a dye-sensitized solar cell is an electrochemical solar cell that is mainly composed of photosensitive dye molecules that absorb visible rays and produce electron-hole pairs, and a transition metal oxide that transfers the produced electrons. A dye-sensitized solar cell can be a dye-sensitized solar cell using nano titanium oxide, i.e., anatase.

A dye-sensitized solar cell can also be produced at a low cost, and since it uses a transparent electrode, it can be applied to external glass walls of a building or a glass greenhouse. However, a conventional dye-sensitized solar cell has not gained wide acceptance for practical use due to its relatively low photoelectric efficiency.

The photoelectric efficiency of a solar cell is proportional to the quantity of electrons produced from the absorption of solar beams. Thus, to increase the photoelectric efficiency, the quantity of electrons should be increased or the electron-hole recombination of the produced and excited electrons should be reduced or prevented. The quantity of produced electrons can be increased by raising the absorption of solar beams or the dye adsorption efficiency.

Particles of an oxide semiconductor of a solar cell should be prepared in a nano-size to increase the dye adsorption efficiency of each unit area, and the reflectivity of a platinum electrode of the solar cell should be increased or a micro-sized oxide semiconductor light scattering agent should be included to increase the absorption of solar beams.

**SUMMARY OF THE INVENTION**

An aspect of an embodiment of the present invention is directed to a dye-sensitized solar cell having a relatively high photoelectric efficiency.

Another aspect of an embodiment of the present invention is directed to a method of fabricating the dye-sensitized solar cell having the relatively high photoelectric efficiency.

According to a first aspect of the invention there is provided a dye-sensitized solar cell. The dye-sensitized solar cell comprises a first electrode, a second electrode, an electrolyte disposed between the first and second electrodes and a light absorption layer disposed between the first and second electrode. The light absorption layer comprises a porous membrane including semiconductor particulates, and a photosensitized dye adsorbed on a surface of the porous membrane. The light absorption layer is characterized in that the porous membrane has a membrane density ranging from 0.83 to 1.97mg/mm$^3$, where the membrane density is a ratio of a porous membrane volume relative to a semiconductor particulate mass.

According to one embodiment of the present invention, a dye-sensitized solar cell is provided. The dye-sensitized solar cell includes a first electrode (that, e.g., includes a conductive transparent substrate); a light absorption layer disposed on a side of the first electrode; a second electrode facing the first electrode; and an electrolyte disposed between the first and second electrodes. The light absorption layer includes: a porous membrane including semiconductor particulates, and a photosensitized dye adsorbed on a surface of the porous membrane. Here, the porous membrane has a membrane density ranging from 0.83 to 1.97mg/mm$^3$, and the membrane density is a ratio of a porous membrane volume relative to a semiconductor particulate mass.

The semiconductor particulate may be of an elementary substance semiconductor, a compound semiconductor, a perovskite compound, or mixtures thereof.

The semiconductor particulates may have an average particle diameter ranging from 5 to 500 nm.

The semiconductor particulate may be loaded on the first electrode in an amount from 40 to 100 mg/mm$^2$.

According to another embodiment of the present invention, a method of fabricating the dye-sensitized solar cell is provided. The method includes forming a porous membrane by coating a composition for forming the porous membrane on a first electrode followed by a mechanical necking treatment; adsorbing a photosensitized dye on a surface of the porous membrane to form a light absorption layer; and forming a second electrode on the light absorption layer followed by injection of an electrolyte.

The composition for forming the porous membrane may include semiconductor particulates.

The mechanical necking may be performed by a pressing method.

According to another embodiment of the present invention, a dye-sensitized solar cell is provided. The dye-sensitized solar cell includes a first electrode; a second electrode; and a light absorption layer disposed between the first and second electrodes. The light absorption layer includes a porous membrane including mechanically necked semiconductor particulates, and a photosensitized dye adsorbed on a surface of the porous membrane. That is, the porous membrane is formed by mechanically necking the semiconductor particulates of the porous membrane.

## BRIEF DESCRIPTION OF THE DRAWINGS

The accompanying drawings, together with the specification, illustrate exemplary embodiments of the present invention, and, together with the description, serve to explain the principles of the present invention.

FIG. 1 is a schematic view showing a dye-sensitized solar cell according to one embodiment of the present invention.

FIG. 2 shows a manufacturing process of a dye-sensitized solar cell according to another embodiment.

FIG. 3A is a photograph showing a cross-section of a first electrode on which a porous membrane is disposed according to Example 2.

FIG. 3B is a photograph showing a cross-section of a first electrode on which a porous membrane is disposed according to Comparative Example 1.

## DETAILED DESCRIPTION

In the following detailed description, only certain exemplary embodiments of the present invention are shown and described, by way of illustration. As those skilled in the art would recognize, the described exemplary embodiments may be modified in various ways, all without departing from the scope of the present invention. Accordingly, the drawings and description are to be regarded as illustrative in nature, and not restrictive.

During driving of a dye-sensitized solar cell, photocharges are generated by optical energy and/or by dye material(s). That is, the dye materials are excited by absorbing light that is transmitted through a conductive transparent substrate.

A dye material is typically adsorbed onto the upper surface of a porous membrane including semiconductor particulates, and the porous membrane is disposed on top of a first electrode including a transparent substrate.

The porous membrane is prepared by coating the first electrode that includes the transparent substrate, such as a glass substrate and a plastic substrate, with a porous membrane material to form a composition including the semiconductor particulates. The composition is then heated at a high temperature ranging from 400 to 600° C to result in necking of the semiconductor particulates within the porous membrane.

When a plastic material is used as the transparent substrate, heat treatment at high temperature may not be performed. Thus, in one embodiment, the heat treatment is carried out at a relatively low temperature of about 150° C. However, in one embodiment, the heat treatment at the relatively low temperature has a problem in that the necking formation efficiency of the semiconductor particulates is deteriorated.

As such, one embodiment of the present invention increases or improves the photoelectric efficiency of a dye-sensitized solar cell by necking the particulates included in the porous membrane through mechanical treatment instead of heat treatment when the porous membrane is fabricated.

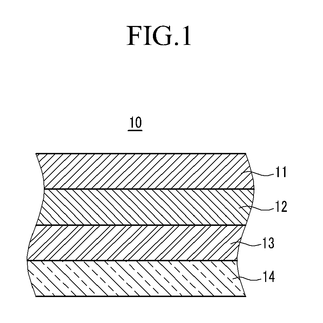

In more detail, FIG. 1 is a schematic view showing a dye-sensitized solar cell 10 according to one embodiment of the present invention.

Referring to FIG. 1, the dye-sensitized solar cell 10 has a stacked (or sandwich) structure in which a first electrode 11 and a second electrode 14 are coupled or connected to each other (e.g., from surface to surface). In one embodiment, the first electrode 11 and the second electrode 14 are two plate-type transparent electrodes. A light absorption layer 12 is disposed on one side of one transparent electrode of the two transparent electrodes 11 and 14, e.g., the first electrode 11. The light absorption layer 12 is disposed on the surface of the first electrode 11 facing the second electrode 14. A space between the two electrodes 11 and 14 is filled with an electrolyte 13. The light absorption layer 12 includes a porous membrane including semiconductor particulates and dye molecules adsorbed by the porous membrane.

In operation, solar beams enter the dye-sensitized solar cell 10, and the dye molecules in the light absorption layer 12 absorb photons. The dye molecules that have absorbed the photons are excited from a ground state, which is referred to as an electron transfer state, to thereby form electron-hole pairs. The excited electrons are injected into a conduction band on the semiconductor particulate interface. The injected electrons are transferred to the first electrode 11 through the interface, and then the electrons are transferred to the second electrode 14, which is an electrode opposite (or an electrode having opposite polarity) to the first electrode 11, through an external circuit. The dye that is oxidized as a result of the electron transfer is reduced by ions in the electrolyte through an oxidation-reduction reaction, and the oxidized ions are involved in a reduction reaction with electrons that have arrived at the interface of the second electrode 14 to achieve charge neutrality.

The first electrode (e.g., working electrode or semiconductor electrode) 11 includes a transparent substrate and a conductive layer disposed on the transparent substrate.

The transparent substrate may be formed of any suitable transparent material adapted to transmit external light, such as glass and/or plastics. Non-limiting examples of the plastics may include polyethylene terephthalate (PET), polyethylene naphthalate (PEN), polycarbonate (PC), polypropylene (PP), polyimide (PI), triacetyl cellulose (TAC), polyethersulfone, and copolymers thereof.

The transparent substrate may be doped with a doping material selected from the group consisting of Ti, In, Ga, Al, and combinations thereof.

A conductive layer is disposed on the transparent substrate.

The conductive layer may include a conductive metal oxide selected from the group consisting of indium tin oxide (ITO), fluorine tin oxide (FTO), $ZnO$-($Ga_2O_3$ or $Al_2O_3$), a tin (Sn)-based oxide, antimony tin oxide (ATO), zinc oxide, and combinations thereof. In one embodiment, the conductive metal oxide is $SnO_2$ and/or ITO because $SnO_2$ and/or ITO have relatively high conductivity, transparency, and/or heat resistance.

The conductive layer may include a mono-layered oxide or a multi-layered conductive metal oxide.

A porous membrane including semiconductive particulates and a light absorption layer 12 including a photosensitive dye absorbed on the surface of the porous membrane are formed on the first electrode 11.

The porous membrane has a relatively (substantially) small and uniform nano-pores, and includes semiconductor particulates having a relatively (substantially) small and uniform average particle size.

The semiconductor particulates may be of an elementary substance semiconductor, which is represented by silicon, a compound semiconductor, and/or a perovskite compound.

The semiconductor may be an n-type semiconductor in which electrons of the conduction band become carriers by being optically excited to provide an anode current. Examples of the compound semiconductor include an oxide including at least one metal selected from the group consisting of Ti, Zr, Sr, Zn, In, Yr, La, V, Mo, W, Sn, Nb, Mg, Al, Y, Sc, Sm, Ga, In, and combinations thereof, especially TiSr. According to one embodiment, the compound semiconductor may be $TiO_2$, $SnO_2$, $ZnO$, $WO_3$, $Nb_2O_5$, $TiSrO_3$, or mixtures thereof. According to another embodiment, the compound semiconductor may be anatase $TiO_2$. The semiconductor is not limited to the above-mentioned materials, and the above-mentioned materials may be used individually or in combination.

The semiconductor particulates may have a large surface area to allow the dye adsorbed onto the surface of the semiconductor particulates to absorb a large amount of light. The semiconductor particulates may have an average particle diameter ranging from 5 to 500 nm, and, more specifically, an average particle diameter ranging from 10 to 50 nm. In one embodiment, when the semiconductor particulates have an average particle diameter of less than 5 nm, there is a relatively large amount of loss while electrons produced from the dye pass through the necked $TiO_2$ and transfer to an external electrode, which is undesirable. By contrast, in another embodiment, when the semiconductor particulates have an average particle diameter of over 500 nm, the amount of dye adsorption is relatively small, which is undesirable.

The semiconductor particulates may be loaded on the first electrode 11 in an amount ranging from 40 to 100 $mg/mm^2$, and more specifically, in an amount ranging from 60 to 80 $mg/mm^2$. In one embodiment, when the semiconductor particulates are loaded in an amount of less than 40 $mg/mm^2$, the first electrode becomes thin to thereby increase an optical transmission rate, which is undesirable because the incident light cannot be utilized effectively. By contrast, in another embodiment, when the semiconductor particulates are loaded in an amount of over 100 $mg/mm^2$, the volume of the first electrode 11 per unit area becomes too large, and the electrons produced by the incident light entering from the outside are combined with holes before they flow to the external electrode. Thus, current cannot be generated sufficiently.

The porous membrane of the present embodiment is prepared through mechanical necking without heat treatment. The membrane density of the porous membrane can be controlled by properly adjusting the conditions for the mechanical necking. The porous membrane of the present embodiment has a relatively lower porosity than the porous membrane fabricated through a heat treatment, but has a relatively higher membrane density.

In more detail, when a ratio of the porous membrane to the mass of the semiconductor particulates in the porous membrane is defined as a density, the porous membrane may have a membrane density (D) ranging from 0.83 to 1.97 mg/mm$^3$, and more specifically, a membrane density ranging from 1.40 to 1.65 mg/mm$^3$. In one embodiment, when the membrane density is lower than 0.83 mg/mm$^3$, the network between the TiO$_2$ particles of the first electrode is not sufficiently formed, and the flow of electrons is thereby deteriorated to result in lower produced current, which is undesirable. By contrast, when the membrane density is higher than 1.97 mg/mm$^3$, it makes the electrons flow better, but, since the specific surface area becomes low, the amount of adsorbed dye is small and this reduces the number of electrons initially generated by light, which is undesirable. Since the porous membrane of the present embodiment has an appropriate membrane density, it allows for an increase in the electrolyte 13 transfer and improves the necking property of the semiconductor particulates.

Also, a sample with the mechanical necking treatment has improved adhesion to an external electrode, compared to a sample without the mechanical necking treatment. This results in an improved current collecting property from the first electrode 11 to the external electrode.

In other words, if the necking is achieved through a conventional heat treatment, an electrical resistance of the conductive substrate in the first electrode is increased to thereby hinder the electron flow toward the external electrode. However, since the present embodiment does not perform the heat treatment, such a problem does not occur, and the mechanical necking treatment process can be continued (e.g., the treatment can be a continuous process) without stopping, which is advantageous in terms of manufacturing efficiency.

In addition, the surface of the porous membrane absorbs the dye that absorbs the outside light and produces excited electrons.

The dye may be a metal composite including at least one material selected from the group consisting of aluminum (Al), platinum (Pt), palladium (Pd), europium (Eu), lead (Pb), iridium (Ir), ruthenium (Ru), etc. Since ruthenium is a platinum-based element and can form many organic metal composites, ruthenium can be used as a dye. An organic dye such as coumarin, porphyrin, xanthene, riboflavin, triphenyl methane, and so on can also be used.

Facing the first electrode 11 formed with the light absorption layer 12, the second electrode (e.g., counter electrode) 14 is disposed. The second electrode 14 includes a transparent substrate and a transparent electrode facing the first electrode 11, and a catalyst electrode formed on the transparent substrate.

The transparent substrate may be composed of a glass and/or a plastic as in the first electrode. Examples of the plastic may include polyethylene terephthalate, polyethylene naphthalate, polycarbonate, polypropylene, polyimide, triacetylcellulose, polyethersulfone, etc.

On the transparent substrate, the transparent electrode is disposed. The transparent electrode may be formed of a transparent material such as indium tin oxide, fluorine tin oxide, antimony tin oxide, zinc oxide, tin oxide, ZnO-Ga$_2$O$_3$, ZnO-Al$_2$O$_3$, etc.

The transparent electrode may be composed of a mono-layered membrane or a multi-layered membrane.

On the transparent electrode, the catalyst electrode is disposed. The catalyst electrode activates a redox couple, and includes a conductive material selected from the group consisting of platinum (Pt), gold (Au), ruthenium (Ru), palladium (Pd), rhodium (Rh), iridium (Ir), osmium (Os), carbon (C), WO$_3$, TiO$_2$, a conductive polymer, and combinations thereof.

Further, the catalyst electrode facing the first electrode 11 may be porous to increase the surface area so that the catalyst effect is improved. For example, Pt and/or Au may have a black state (herein, "black state" is referred to as the state in which nothing is supported on the supported body), and carbon may have a porous state. Particularly, the platinum black state may be obtained by an anodic oxidation method, a chloroplatinic acid method, etc. Further, the porous carbon may be obtained by sintering carbon particulates and/or firing organic polymers.

The transparent substrate of the first electrode 11 is laminated with the transparent substrate of the second electrode 14 by an adhesive agent, or welded by ultrasonic waves, heat, infrared rays, and vibration, or they may be laminated by any suitable welding method. The electrolyte 13 is injected (or disposed) into a hole (or cavity) penetrating the second electrode 14 to be interposed (or impregnated) between the first electrode 11 and the second electrode 14. The electrolyte 13 is uniformly dispersed into the inside of the porous membrane in the light absorption layer 12.

The electrolyte 13 may be composed of an electrolyte solution that is an iodide/triodide pair. The iodide/triodide pair receives and transfers electrons from the second (or counter) electrode 14 to the dye through an oxidation-reduction reaction. The electrolyte 13 may be a solution prepared by dissolving iodine in acetonitrile, but it is not limited to the iodine acetonitrile solution and may be any suitable substance that has a suitable conductivity (or suitable hole conductivity).

The hole (or cavity) penetrating the second electrode 14 is sealed by an adhesive agent and a cover glass. Although the present embodiment has been described with a liquid-phase electrolyte 13, a solid-phase electrolyte may also be used and this is also within the scope and range of the present invention.

A dye-sensitized solar cell (e.g., cell 10) according to one embodiment may be fabricated as follows: a porous membrane is formed by coating a composition for forming the porous membrane on a first electrode (e.g., electrode 11) followed by a mechanical necking treatment; a photosensitized dye is adsorbed on the porous membrane surface to form a light absorption layer (e.g., layer 12); and a second electrode (e.g., electrode 14) is formed on the light absorption layer followed by injection of an electrolyte (e.g., electrolyte 13).

The formation of the first electrode (e.g., electrode 11) and the light absorption layer (e.g., electrode 12) is described in more detail below.

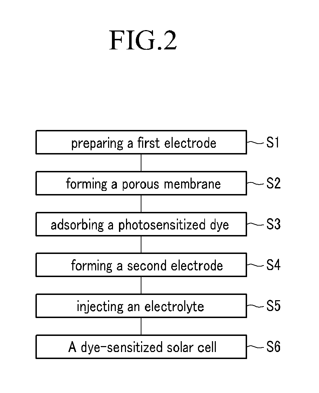

FIG. 2 shows a manufacturing process of a dye-sensitized solar cell according to another embodiment. Referring to FIG. 2, a method of fabricating the dye-sensitized solar cell is described in more detail below. In step S1 of the method, a first electrode is prepared.

The first electrode may be made as described above using a suitable method. For example, the first electrode may be fabricated by forming a conductive layer including a conductive material on a transparent substrate using electroplating, and/or a physical vapor deposition (PVD) method such as sputtering and electron beam deposition.

In step S2, the first electrode is coated with a porous membrane forming composition, and goes through mechanical necking to thereby form a porous membrane.

The composition for forming the porous membrane may be prepared by dispersing semiconductor particulates in a solvent.

The semiconductor particulates can be the same as described before, and the solvent may be selected from alcohols, such as ethanol, isopropylalcohol, n-propylalcohol and butanol; water; dimethylacetamide; dimethylsulfoxide; and N-methylpyrrolidone.

According to an embodiment, coating the first electrode with the porous membrane forming composition may be carried out in a method selected from the group consisting of screen printing, spray coating, doctor blade coating, gravure coating, dip coating, silk screening, painting, slit die coating, spin coating, roll coating, decalomania coating, and combinations thereof according to the viscosity of the composition, but the present invention is not limited thereto. According to another embodiment, a doctor blade coating method that is capable of coating a porous membrane in a uniform thickness may be used.

Mechanical necking is performed to the porous membrane forming composition on the first electrode.

The mechanical necking may be performed by a pressing method. In more detail, the mechanical necking may be carried out by a method selected from the group consisting of roll pressing, single-axial pressing, multi-axial pressing, and combinations thereof. More specifically, the mechanical necking may be performed by a roll pressing method (or by roll pressing) that can easily result in necking among particles.

The mechanical necking treatment forms necking among the semiconductor particulates included in the porous membrane without a heat treatment used in the formation of a conventional porous membrane, and thereby improves photoelectric efficiency of the solar cell. Also, the mechanical necking treatment is suitable for a continuous process to thereby reduce production cost in terms of mass production.

In step S3, a dye is adsorbed onto the above-prepared porous membrane and the dye is deposited onto the porous membrane by spraying a dispersion solution including the dye thereto, coating the porous membrane with the dispersion solution, and/or impregnating it in the dispersion solution.

In one embodiment, the adsorption of the dye occurs in 12 hours after the first electrode with the porous membrane is disposed in the dispersion solution including the dye, and the adsorption time may be shortened by applying heat thereto. The dye can as described before, and the solvent for dispersing the dye may be acetonitrile, dichloromethane, and an alcohol-based solvent, but the present invention is not thereby limited.

The dispersion solution including the dye may further include organic pigment of various suitable colors to improve absorption of long-wavelength visible light and to further improve efficiency.

After the dye layer is formed, a single-layered light absorption layer (e.g., layer 12) may be prepared by rinsing the porous membrane with the dye layer with a solvent.

In step S4, a second electrode is prepared and laminated with the first electrode with the dye adsorbed thereto.

As described above, the second electrode includes a transparent substrate, a transparent electrode, and a catalyst electrode, and the structure of the second electrode may be formed as described above.

The second electrode may be laminated with the first electrode having the light absorption layer thereon.

The first electrode and the second electrode are coupled or connected to each other (e.g., face to face) by using an adhesive agent. The adhesive agent may be a thermoplastic polymer film, such as SURLYN, produced by the DuPont Company. The thermoplastic polymer film is placed between the two electrodes and heat and pressure are applied to the electrodes. An epoxy resin or an ultraviolet (UV) ray initiator may be used as the adhesive agent. The adhesion may be hardened after heat treatment and/or UV treatment.

In step S5, one or more fine holes (or cavities) are formed to penetrate the first electrode and the second electrode, and an electrolyte is injected into the space between the two electrodes through the holes (or cavities). In step S6, the external part of the holes (or cavities) are sealed with an adhesive agent to thereby prepare a dye-sensitized solar cell of the present embodiment.

The electrolyte can the same as described before.

According to the fabrication method of the present embodiment, the necking is formed among the semiconductor particulates in the porous membrane through the mechanical necking treatment without performing the heat treatment.

The method makes it possible to perform processing continuously and control the porous membrane to have a relatively high necking efficiency. In more detail, when a plastic transparent substrate is used, a relatively high necking efficiency can be acquired without heat treatment at a high temperature. Also, a dye-sensitized solar cell fabricated in the method described above includes a porous membrane having a controlled membrane density to thereby have an excellent or high photoelectric efficiency.

The following examples illustrate the present invention in more detail. However, the present invention is not limited by these examples.

**Example 1**

A first electrode was fabricated by forming a conductive layer of tin oxide on a transparent substrate formed of polyethylene terephthalate polymer at 1 cm x 1 cm to have a surface resistance of 10Ω .

A porous membrane forming composition was prepared by dispersing 30wt% $TiO_2$ semiconductor particulates having an average particle diameter of 20 nm in a 10 ml alcohol mixed solution. The first electrode was coated with the porous membrane forming composition by using a doctor blade method at a speed of 5mm/sec. After being dried, the first electrode was compressed at a pressure level, which may be predetermined, to thereby form a porous membrane including $TiO_2$. The thickness of the porous membrane was 0.035mm.

Subsequently, the first electrode with the porous membrane was disposed in 0.3 mM ruthenium (4,4-dicarboxyl-2,2'-bipyridine)$_2$(NCS)$_2$ solution for 24 hours to allow the porous membrane to be absorbed with a dye thereto. The porous membrane with the dye adsorbed thereto was rinsed with ethanol.

A second electrode was fabricated by forming a transparent electrode, which was formed of tin oxide and had a surface resistance of 10Ω , and a catalyst electrode, which was formed of platinum and had a surface resistance of 0.5Q , on a transparent substrate formed of a polyethylene terephthalate polymer at 1 cm x 1 cm. A hole (or cavity) was formed to penetrate the second electrode by using a drill with a diameter of 0.75mm.

The first electrode and the second electrode were disposed to oppose each other such that the second electrode could face the porous membrane of the first electrode. Then, a thermoplastic polymer film having a thickness of 60μm was disposed between the transparent substrate of the first electrode and the transparent substrate of the second electrode, and compressed at 100° C for 9 seconds to thereby laminate the first electrode with the second electrode.

An electrolyte was injected through the hole (cavity) penetrating the second electrode, and the hole (or cavity) was plugged with a thermoplastic resin to thereby complete the fabrication of a solar cell. Herein, the electrolyte was a solution prepared by dissolving 21.928g of tetrapropylammonium iodide and 1.931g of iodine ($I_2$) in a 100ml mixed solvent of 80 volume% ethylene carbonate and 20 volume% acetonitrile.

**Example 2**

A first electrode was fabricated by forming a conductive layer of tin oxide on a transparent substrate formed of polyethylene terephthalate polymer at 1 cm x 1 cm to have a surface resistance of 10Ω .

A porous membrane forming composition was prepared by dispersing 30wt% $TiO_2$ semiconductor particulate having an average particle diameter of 20 nm in 10 ml alcohol mixed solution. The first electrode was coated with the porous membrane forming composition by using a doctor blade method at a speed of 5mm/sec. After being dried, the first electrode was compressed at a pressure level, which may be predetermined, to thereby form a porous membrane including $TiO_2$. The thickness of the porous membrane was 0.017mm.

Subsequently, the first electrode with the porous membrane was disposed in a 0.3 mM ruthenium (4,4-dicarboxyl-2,2'-bipyridine)$_2$(NCS)$_2$ solution for 24 hours to allow the porous membrane to be absorbed with a dye thereto. The porous membrane with the dye adsorbed thereto was rinsed with ethanol.

A second electrode was fabricated by forming a transparent electrode, which was formed of tin oxide and had a surface resistance of 10Ω , and a catalyst electrode, which was formed of platinum and had a surface resistance of 0.5Q , on a transparent substrate formed of polyethylene terephthalate polymer at 1 cm x 1 cm. A hole (or cavity) was formed to penetrate the second electrode by using a drill with a diameter of 0.75mm.

The first electrode and the second electrode were disposed to oppose each other such that the second electrode could face the porous membrane of the first electrode. Then, a thermoplastic polymer film having a thickness of 60μm was disposed between the transparent substrate of the first electrode and the transparent substrate of the second electrode, and compressed at 100° C for 9 seconds to thereby laminate the first electrode with the second electrode.

An electrolyte was injected through the hole (or cavity) penetrating the second electrode, and the hole (or cavity) was plugged with a thermoplastic polymer film and a cover glass to thereby complete the fabrication of a solar cell. Herein, the electrolyte was a solution prepared by dissolving 21.928g of tetrapropylammonium iodide and 1.931 g of iodine ($I_2$) in a 100ml mixed solvent of 80 volume% ethylene carbonate and 20 volume% acetonitrile.

**Example 3**

A first electrode was fabricated by forming a conductive layer of tin oxide on a transparent substrate formed of polyethylene terephthalate polymer at 1 cm x 1 cm to have a surface resistance of 10Ω .

A porous membrane forming composition was prepared by dispersing 30wt% $TiO_2$ semiconductor particulate having an average particle diameter of 20 nm in a 10 ml alcohol mixed solution. The first electrode was coated with the porous membrane forming composition by using a doctor blade method at a speed of 5mm/sec. After being dried, the first electrode was compressed at a pressure level, which may be predetermined, to thereby form a porous membrane including $TiO_2$. The thickness of the porous membrane was 0.015mm.

Subsequently, the first electrode with the porous membrane was disposed in 0.3 mM ruthenium (4,4-dicarboxyl-2,2'-bipyridine)$_2$(NCS)$_2$ solution for 24 hours to allow the porous membrane to be absorbed with a dye thereto. The porous membrane with the dye adsorbed thereto was rinsed with ethanol.

A second electrode was fabricated by forming a transparent electrode, which was formed of tin oxide and had a surface resistance of 10Ω, and a catalyst electrode, which was formed of platinum and had a surface resistance of 0.5Q , on a transparent substrate formed of polyethylene terephthalate polymer at 1 cm x 1 cm. A hole (or cavity) was formed to penetrate the second electrode by using a drill with a diameter of 0.75mm.

The first electrode and the second electrode were disposed to oppose each other such that the second electrode could face the porous membrane of the first electrode. Then, a thermoplastic polymer film having a thickness of $60\mu m$ was disposed between the transparent substrate of the first electrode and the transparent substrate of the second electrode, and compressed at 100° C for 9 seconds to thereby laminate the first electrode with the second electrode.

An electrolyte was injected through the hole (or cavity) penetrating the second electrode, and the hole (or cavity) was plugged with a thermoplastic polymer film and a cover glass to thereby complete the fabrication of a solar cell. Herein, the electrolyte was a solution prepared by dissolving 21.928g of tetrapropylammonium iodide and 1.931 g of iodine ($I_2$) in a 100ml mixed solvent of 80 volume% ethylene carbonate and 20 volume% acetonitrile.

**Comparative Example 1**

A first electrode was fabricated by forming a coating layer of tin oxide on a transparent substrate formed of polyethylene terephthalate polymer at 1 cm x 1 cm to have a surface resistance of 10Ω.

A porous membrane forming composition was prepared by dispersing 30wt% $TiO_2$ semiconductor particulate having an average particle diameter of 20 nm in a 10 ml alcohol mixed solution. The first electrode was coated with the porous membrane forming composition by using a doctor blade method at a speed of 5mm/sec. Heat treatment was then performed to the first electrode at 150° C for 30 minutes to thereby form a porous titanium oxide membrane having a thickness of 0.046mm.

Subsequently, the first electrode with the porous membrane was disposed in a 0.3 mM ruthenium (4,4-dicarboxyl-2,2'-bipyridine)$_2$(NCS)$_2$ solution for 24 hours to allow the porous membrane to be absorbed with a dye thereto. The porous membrane with the dye adsorbed thereto was rinsed with ethanol.

A second electrode was fabricated by forming a transparent electrode, which was formed of tin oxide and had a surface resistance of 10Ω , and a catalyst electrode, which was formed of platinum and had a surface resistance of 0.5Q , on a transparent substrate formed of polyethylene terephthalate polymer at 1 cm x 1 cm. A hole (or cavity) was formed to penetrate the second substrate and the second electrode by using a drill with a diameter of 0.75mm.

The first electrode and the second electrode were disposed to oppose each other such that the second electrode could face the porous membrane of the first electrode. Then, a thermoplastic polymer film having a thickness of $60\mu m$ was disposed between the transparent substrate of the first electrode and the transparent substrate of the second electrode, and compressed at 100° C for 9 seconds to thereby laminate the first electrode with the second electrode.

An electrolyte was injected through the hole (or cavity) penetrating the second electrode, and the hole was plugged with a thermoplastic polymer film and a cover glass to thereby complete the fabrication of a solar cell. Herein, the electrolyte was a solution prepared by dissolving 21.928g of tetrapropylammonium iodide and 1.931 g of iodine ($I_2$) in a 100ml mixed solvent of 80 volume% ethylene carbonate and 20 volume% acetonitrile.

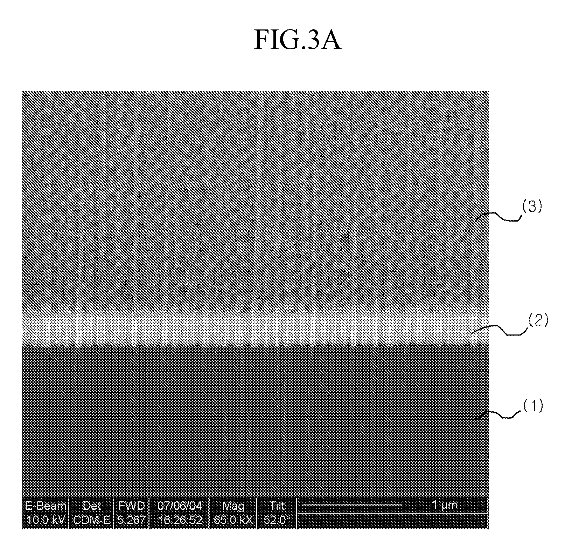

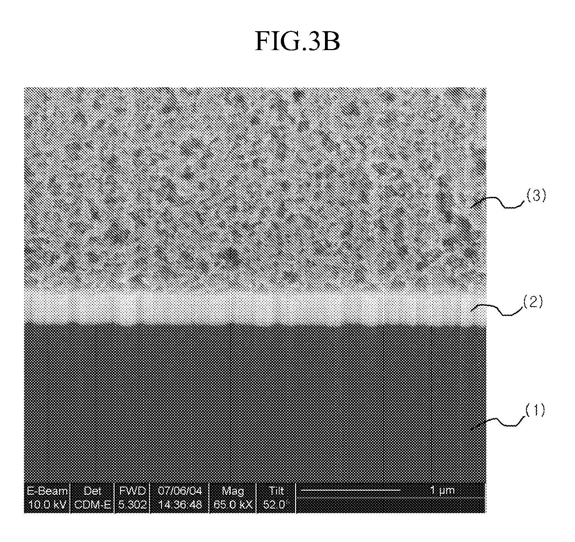

Cross sections of the first electrodes with the porous membranes prepared according to Example 2 and Comparative Example 1 were observed with a scanning electron microscope. The results are as shown in FIGS. 3A and 3B.

FIG. 3A is a photograph showing a cross-section of the first electrode with the porous membrane thereon fabricated according to Example 2, and FIG. 3B is a photograph showing a cross-section of the first electrode with the porous membrane thereon fabricated according to Comparative Example 1. In FIGs. 3A and 3B, reference numeral '1' denotes the transparent substrate, and reference numeral '2' denotes the conductive layer, while reference numeral '3' denotes the porous membrane.

It can be seen from FIGS. 3A and 3B that the porous membrane of Example 2 had more densely connected particles than the porous membrane of Comparative Example 1.

The membrane densities of the first electrodes with the porous membrane prepared according to Examples 1 to 3 and Comparative Example 1 were measured. The results are presented in the following Table 1.

Table 1

|  | Comp. Ex. 1 | Example1 | Example2 | Example3 |
|---|---|---|---|---|
| Substrate mass (mg) | 64.71 | 66.73 | 67.64 | 66.9 |
| First electrode mass (mg) | 65.2 | 67.25 | 68.15 | 67.41 |
| TiO$_2$ mass (mg) | 0.49 | 0.52 | 0.51 | 0.51 |
| Membrane thickness (mm) | 0.046 | 0.035 | 0.017 | 0.015 |
| Electrode area 2 (mm$^2$) | 18 | 18 | 18 | 18 |
| Membrane density (mg/mm$^3$) | 0.6 | 0.83 | 1.64 | 1.97 |

It can be seen from the Table 1 that the first electrodes of Examples 1 to 3, which included the porous membrane obtained through mechanical necking, showed higher membrane density than the first electrode of Comparative Example 1, which included the porous membrane obtained through heat treatment.

Photocurrent voltages of the dye-sensitized solar cells according to the Examples 1 to 3 and Comparative Example 1 were measured, and the open-circuit voltage (Voc), a current density (short-circuit current: Jsc), and a fill factor (FF) were calculated based on a curve line of the measured photocurrent voltages. The measurement results are shown in the following Table 2.

Herein, a xenon lamp of Oriel, 01193, was used as a light source, and the solar condition (AM 1.5) of the xenon lamp was corrected by using a standard solar cell (Fraunhofer Institut Solare Energiesysteme, Certificate No. C-ISE369, type of material: Mono-Si + KG filter).

The fill factor is a value obtained by dividing Vmp×Jmp, where Vmp is a current density and Jmp is a voltage at a maximal electric power voltage, by Voc×Jsc. The photovoltaic efficiency ($\eta$) of a solar cell is a conversion efficiency of solar energy to electrical energy, which can be obtained by dividing a solar cell electrical energy (current× voltage× fill factor) by energy per unit area (P$_{inc}$) as shown the following Equation 1.

Equation 1

$$\eta = (Voc \cdot Jsc \cdot FF)/(P_{inc})$$

wherein the P$_{inc}$ is 100mW/cm$^2$ (1sun).

Table 2

|  | Comp. Ex. 1 | Example1 | Example2 | Example3 |
|---|---|---|---|---|
| Jsc (mA/cm$^2$) | 2.65 | 4.79 | 10.68 | 8.7 |
| Voc (mV) | 730 | 729 | 759 | 768 |
| F.F | 0.77 | 0.74 | 0.63 | 0.64 |
| Efficiency (%) | 1.50 | 2.57 | 5.07 | 4.29 |

It can be seen from the Table 2 that the solar cells of Examples 1 to 3 having the porous membranes obtained through mechanical necking, showed photoelectric efficiencies that are higher than the solar cell of Comparative Example 1 having the porous membrane obtained through heat treatment.

In view of the foregoing, as the membrane density of a porous membrane increases, the photoelectric efficiency becomes high as does the Jsc. When Examples 2 and 3 are compared with each other, the membrane density of the porous membrane included in the solar cell of Example 3 was higher than the membrane density of the porous membrane in the solar cell of Example 2. However, the photoelectric efficiency was lower. This may be because the excessively high membrane density of the porous membrane in the solar cell of Example 3 decreased the porosity and damaged the porous membrane by causing cracks therein, which leads to a decrease in the photoelectric efficiency.

As such, the above experimental result shows that a porous membrane should have a relatively high photoelectric efficiency when the membrane density is at a range from 0.83 to 1.97mg/mm$^3$.

In view of the foregoing, the present invention improves the photoelectric efficiency of a dye-sensitized solar cell by controlling the membrane density of a porous membrane through unfired mechanical necking.

**Claims**

1. A dye-sensitized solar cell (10) comprising:

   a first electrode (11);
   a second electrode (14); an electrolyte (13) disposed between the first and second electrodes (11, 14) and
   a light absorption layer (12) disposed between the first and second electrode (14), wherein the light absorption layer (12) comprises:

      a porous membrane including semiconductor particulates, and
      a photosensitized dye adsorbed on a surface of the porous membrane,

   **characterized in that** the porous membrane has a membrane density ranging from 0.83 to 1.97mg/mm$^3$, where the membrane density is a ratio of a porous membrane volume relative to a semiconductor particulate mass.

2. The dye-sensitized solar cell of claim 1, wherein the membrane density of the porous membrane ranges from 1.40 to 1.65 mg/mm$^3$.

3. The dye-sensitized solar cell of claims 1 or 2, wherein the semiconductor particulates comprise a material selected from the group consisting of an elementary substance semiconductor, a compound semiconductor, a perovskite compound, and combinations thereof.

4. The dye-sensitized solar cell of claim 3, wherein the semiconductor particulates comprise an oxide including at least one metal selected from the group consisting of Ti, Zr, Sr, Zn, In, Yr, La, V, Mo, W, Sn, Nb, Mg, Al, Y, Sc, Sm, Ga, In, and combinations thereof.

5. The dye-sensitized solar cell of claims 3 or 4, wherein the semiconductor particulates have an average particle diameter ranging from 5 to 500 nm.

6. The dye-sensitized solar cell of any of claims 3 to 5, wherein the semiconductor particulates are loaded on the first electrode in an amount from 40 to 100 mg/mm$^2$.

7. The dye-sensitized solar cell of any of the preceding claims, wherein the dye comprises at least one material selected from the group consisting of a metal composite including at least one composite selected from the group consisting of aluminum (Al), platinum (Pt), palladium (Pd), europium (Eu), lead (Pb), iridium (1r), ruthenium (Ru), and combinations thereof; an organic dye; and combinations thereof.

8. The dye-sensitized solar cell of any of the preceding claims, wherein the first electrode (11) comprises:

   a transparent substrate; and
   a conductive layer, and
   the conductive layer comprises a conductive metal oxide selected from the group consisting of indium tin oxide (TO), fluorine tin oxide (FTO), ZnO-(Ga$_2$O$_3$ or Al$_2$O$_3$), a tin-based oxide, antimony tin oxide (ATO), zinc oxide, and combinations thereof.

9. The dye-sensitized solar cell of claim 8, wherein the transparent substrate is a plastic substrate.

10. The dye-sensitized solar cell of claim 9, wherein the plastic substrate comprises a material selected from the group consisting of polyethylene terephthalate, polyethylene naphthalate, polycarbonate, polypropylene, polyimide, triacetylcellulose, polyethersulfone, and combinations thereof.

11. The dye-sensitized solar cell of any of the preceding claims, wherein the porous membrane is formed by a pressing method to mechanically neck the semiconductor particulates of the porous membrane.

12. The dye-sensitized solar cell of claim 11, wherein the porous membrane is formed by using only a mechanical necking treatment.

13. A method of fabricating a dye-sensitized solar cell (10), the method comprising:

forming a porous membrane by coating a composition for forming the porous membrane on a first electrode (11) followed by a mechanical necking treatment;
adsorbing a photosensitized dye on a surface of the porous membrane to form a light absorption layer (12); and
forming a second electrode (14) on the light absorption layer (12) followed by injection of an electrolyte (13).

14. The method of claim 13, wherein the composition for forming the porous membrane comprises semiconductor particulates.

15. The method of claim 14, wherein the semiconductor particulates comprise a material selected from the group consisting of an elementary substance semiconductor, a compound semiconductor, a perovskite compound, and combinations thereof.

16. The method of claim 15, wherein the semiconductor particulates comprise an oxide including at least one metal selected from the group consisting of Ti, Zr, Sr, Zn, In, Yr, La, V, Mo, W, Sn, Nb, Mg, Al, Y, Sc, Sm, Ga, In, and combinations thereof.

17. The method of any of claims 14 to 16, wherein the semiconductor particulates have an average particle diameter ranging from 5 to 500 nm.

18. The method of any of claims 14 to 17, wherein the mechanical necking is performed by a pressing method.

# FIG.1

# FIG.2

| | |
|---|---|
| preparing a first electrode | ─S1 |
| forming a porous membrane | ─S2 |
| adsorbing a photosensitized dye | ─S3 |
| forming a second electrode | ─S4 |
| injecting an electrolyte | ─S5 |
| A dye-sensitized solar cell | ─S6 |

# FIG.3A

## FIG.3B

E-Beam | Det | FWD | 07/06/04 | Mag | Tilt | 1 µm
10.0 kV | CDM-E | 5.302 | 14:36:48 | 65.0 kX | 52.0

(3)
(2)
(1)